# EUROPÄISCHE PATENTSCHRIFT

(11) **EP 4 439 105 B1**
(45) Veröffentlichungstag und Bekanntmachung des Hinweises auf die Patenterteilung: **26.03.2025**
(21) Anmeldenummer: 24166494.5
(22) Anmeldetag: 26.03.2024
(51) Int. Cl.: G01R 33/30, G01R 33/31

(54) **VERWENDUNG FUNKTIONSSPEZIFISCHER GASE IN EINER MAS-MIKROGASTURBINE FÜR DIE FESTKÖRPER NMR**
USE OF FUNCTION-SPECIFIC GASES IN AN MAS MICROGAS TURBINE FOR SOLID-STATE NMR
UTILISATION DE GAZ SPÉCIFIQUES AUX FONCTIONS DANS UNE MICROTURBINE À GAZ MAS POUR LA RMN À L'ÉTAT SOLIDE

(30) Priorität: 29.03.2023 DE 102023202880
(43) Veröffentlichungstag der Anmeldung: 02.10.2024
(73) Patentinhaber: Bruker BioSpin GmbH & Co. KG, 76275 Ettlingen (DE)
(72) Erfinder: Simmler, Rico, 76131 Karlsruhe (DE); Osen, David, 76275 Ettlingen (DE); Podadera Sanchez, Daniel, 67160 Wissembourg (FR); Becker, Lukas, 76337 Waldbronn (DE)
(74) Vertreter: Kohler Schmid Möbus Patentanwälte

(56) Entgegenhaltungen:
- CN-A- 114 673 569
- US-A- 5 508 615
- US-A1- 2009 021 260
- JIANG Y. J. ET AL: "Efficient stator/rotor assembly for magic-angle spinning NMR", REVIEW OF SCIENTIFIC INSTRUMENTS, vol. 58, no. 5, 1 May 1987 (1987-05-01), 2 Huntington Quadrangle, Melville, NY 11747, pages 755 - 758, XP093153689, ISSN: 0034-6748, DOI: 10.1063/1.1139626
- BOULEAU E. ET AL: "Pushing NMR sensitivity limits using dynamic nuclear polarization with closed-loop cryogenic helium sample spinning", CHEMICAL SCIENCE, vol. 6, no. 12, 1 January 2015 (2015-01-01), United Kingdom, pages 6806 - 6812, XP093186522, ISSN: 2041-6520, DOI: 10.1039/C5SC02819A
- SESTI ERIKA L ET AL: "Magic angle spinning NMR below 6?K with a computational fluid dynamics analysis of fluid flow and temperature gradients", JOURNAL OF MAGNETIC RESONANCE, ACADEMIC PRESS, ORLANDO, FL, US, vol. 286, 11 November 2017 (2017-11-11), pages 1 - 9, XP085336301, ISSN: 1090-7807, DOI: 10.1016/J.JMR.2017.11.002

## Beschreibung

Die Erfindung betrifft ein Verfahren zum Betrieb einer NMR-Apparatur, die ein MAS-System aufweist mit einer MAS-Turbine umfassend einen MAS-Stator zur Aufnahme eines länglichen MAS-Rotors, wobei im MAS-Stator getrennte Gaszuführungen für die Lagerung und für den Antrieb des MAS-Rotors angeordnet sind, sowie eine NMR-Apparatur, die zur Durchführung des Verfahrens nach einem der vorhergehenden Ansprüche ausgestaltet ist, wobei dem MAS-Stator ein Gas oder Gasgemisch durch die getrennten Gaszuführungen zugeführt wird, wobei ein Gas oder Gasgemisch dem MAS-Stator für den Antrieb des MAS-Rotors durch eine erste Gaszuführung und für die Lagerung des MAS-Rotors durch eine zweite Gaszuführung zugeführt wird, und wobei eine Druckbeaufschlagung des Gases oder Gasgemisches vor der Zufuhr in den MAS-Stator jeweils separat geregelt wird.

Eine NMR-Apparatur mit einem solchen MAS-System sowie ein entsprechendes Betriebsverfahren sind an sich bekannt, etwa aus dem Artikel von JIANG, Y. J., et al. Efficient stator/rotor assembly for magic-angle spinning NMR. Review of scientific instruments, 1987, 58. Jg., Nr. 5, S. 755-758. DOI: https://doi.org/10.1063/1.1139626 [recherchiert und aufgerufen am 01.12.2023] (= Referenz [0]).

Ähnliche Apparaturen sind auch bekannt aus der US 5 508 615 A (= Referenz [1]) oder auch aus dem Artikel von K.R. Thurber et al., "Biomolecular solid state NMR with magic-angle spinning at 25 K" in Journal of Magnetic Resonance 195 (2008) 179-186 (= Referenz [2]).

### Hintergrund der Erfindung

Die vorliegende Erfindung betrifft allgemein den Bereich der Magnetresonanz. Kernspinresonanz(NMR)-Spektroskopie ist eine kommerziell weit verbreitete Methode der der instrumentellen Analytik zur Charakterisierung der chemischen Zusammensetzung von Substanzen. Dabei werden in eine Messprobe, die sich in einem starken, statischen Magnetfeld befindet, wodurch es zur Ausrichtung von Kernspins in der Messsubstanz kommt, Hochfrequenz-Pulse eingestrahlt, und die elektromagnetische Reaktion der Messprobe wird vermessen. Sodann werden die Informationen integral über einen gewissen Bereich der Messprobe, das sogenannte aktive Volumen, gewonnen und zur Bestimmung der chemischen Zusammensetzung ausgewertet.

Bei der Festkörper-NMR-Spektroskopie ist es weiter bekannt, zur Verringerung von Linienverbreiterungen aufgrund anisotroper Wechselwirkungen eine NMR-Probe während der spektroskopischen Vermessung unter dem so genannten "Magischen Winkel" von arctan√2 ≈ 54,74° gegenüber dem statischen Magnetfeld verkippt mit hoher Frequenz (typisch einige kHz) rotieren zu lassen ("MAS" = Magic Angle Spinning). Dazu wird die Probe in einen MAS-Rotor gefüllt. MAS-Rotoren sind in der Regel einseitig offene, zylindrische Röhrchen, die mit einer Kappe verschlossen sind, wobei die Kappe mit Flügelelementen, insbesondere Schaufelrädchen, versehen ist. Der MAS-Rotor wird in einem MAS-Stator angeordnet, und mit Gasdruck wird der MAS-Rotor über die Flügelelemente für die Rotation angetrieben. Die Gesamtheit aus MAS-Rotor und MAS-Stator wird MAS-Turbine genannt.

Bei der Rotation der NMR-Probe in einem umgebenden Gas erwärmt sich die Wand des MAS-Rotors durch die Gasreibung. Dies führt zu einer inhomogenen Temperaturverteilung über der Probensubstanz und zu unerwünschter Erwärmung der Probensubstanz. Daher wird üblicherweise der MAS-Rotor mit der NMR-Probe während der Messung mittels Zufuhr eines Temperiergases auf einer gewünschten Temperatur gehalten, wie beispielsweise in der EP 3 301 467 B1 (=Referenz [3]) beschrieben ist, wo ebenfalls ein MAS-System mit ähnlichen Merkmalen zu den eingangs definierten verwendet wird.

### Spezieller Stand der Technik

Durch den Einsatz von alternativen Gasen (z.B. Helium statt Stickstoff) für Lagerung und Antrieb des MAS-Rotors können höhere Rotationsgeschwindigkeiten im MAS-System für die Festkörper-NMR erreicht werden. Durch die Verwendung von Helium in der Lagerung entstehen jedoch hohe zusätzliche Kosten für den Anwender. Des Weiteren ist die Sprühfestigkeit in Helium reduziert. Außerdem ist dann eine Neuauslegung der Lager- und Antriebsdüsen erforderlich. In konventionellen MAS-Statoren sind die Düsenöffnungen und die Lagerspaltbreiten üblicherweise auf die Dichte und Viskosität von Stickstoff ausgelegt, da dieses Gas konventionell aufgrund seiner Inertgas-Eigenschaften, seiner guten Verfügbarkeit und des niedrigen Preises in Laboren weltweit angewendet wird.

So wird etwa in US 2010/0026302 A1 (=Referenz [4]) ein CryoMAS-System für Hochfeldmagneten beschrieben, in welchem der MAS-Rotor auch bei sehr niedrigen Temperaturen bis zu 20K oder bei höheren Drehgeschwindigkeiten betrieben werden kann. Für diese Fälle empfiehlt Referenz [4] den Einsatz von Helium anstelle von Stickstoff als Lager- und Antriebsgas.

In einem wissenschaftlichen Artikel von E. Bouleau et al "Pushing NMR sensitivity limits using dynamic nuclear polarization with closed-loop cryogenic helium sample spinning", Chem. Sci. (2015) 6, 6806 (=Referenz [5]), wird die Verwendung von Helium sowohl als Kühlgas als auch als Antriebsgas für eine DNP-MAS-Turbine beschrieben.

Ebenfalls für die Anwendung bei sehr niedrigen Temperaturen beschreibt Bouleau in der US 9 995 802 B2 (=Referenz [6]) einen MAS-Rotor, der entweder mit Stickstoff oder mit Helium als Kühl- und Antriebsgas betrieben werden kann.

Die WO 2021/097382 A1 (=Referenz [7]) beschreibt die Verwendung von Diamant als Werkstoff für einen MAS-Rotor zur Erhöhung der möglichen Rotationsgeschwindigkeit. In diesem Zusammenhang wird auch die Verwendung von Helium als Antriebsgas beschrieben.

In der bereits eingangs zitierten Referenz [2] wird die Verwendung von Stickstoff als Antriebs- und Lager-Gas für die MAS-Rotation sowie von kaltem Helium für VT (also nur zur Temperierung der NMR-Probe) beschrieben. Ähnliches offenbart auch ein wissenschaftlicher Artikel von W. H. Potter, "Apparatus to Rotate Samples Rapidly at Temperatures Less than 2 K in High Transverse Magnetic Fields" in Review of Scientific Instruments 42, 618 (1971) (=Referenz [8]). Hier wird wiederum Helium als Kühl- und Antriebsgas erwähnt.

Die ebenfalls bereits eingangs zitierte Referenz [1] beschreibt einen "Supersonic Sample Spinner", also einen MAS-Rotor, der im Überschall-Bereich rotieren soll. Dieser kann gemäß Referenz [1] entweder rein mit Helium betrieben (also gelagert und angetrieben) werden oder aber mit einem Helium/Stickstoff-Gemisch zur Reduktion der Lager-Erhitzung durch die schnelle Rotation des MAS-Rotors. Bis zu 5% Helium in Stickstoff soll demnach möglich sein, ohne damit erhebliche Probleme eines Spannungsüberschlags zwischen MAS-Rotor und MAS-Stator im Betrieb hervorzurufen.

Auch die bereits eingangs zitierte Referenz [0] erwähnt lediglich den Betrieb eines MAS-Systems mit einem einzigen, niemals jedoch simultan mit mehreren unterschiedlichen Gasen oder Gasgemischen.

Eine allgemeine Tendenz in der MAS-Technik geht dahin, die MAS-Rotoren mit immer größeren Rotationsfrequenzen zu betreiben. Als begrenzender Faktor hierfür wird in der Literatur immer die Schallgeschwindigkeit des Antriebsgases genannt.

Die Wirksamkeit von Stickstoff als Antriebsgas lässt bereits vor Erreichen der Schallgeschwindigkeit nach. Andere Gase (z.B. Helium) weisen aufgrund ihrer höheren Schallgeschwindigkeit und/oder anderer Viskosität vorteilhafte Eigenschaften auf für den Einsatz bei MAS-Systemen für die Festkörper-NMR mit MAS-Rotoren, welche besonders schnell rotieren sollen.

Dann erscheint es bei einer beabsichtigten höheren Rotationsfrequenz des MAS-Rotors womöglich opportun, das bis dato verwendete Antriebsgas auszutauschen gegen ein anderes Gas mit höherer Schallgeschwindigkeit, also beispielsweise Stickstoff gegen Helium. Dies ist zwar im Prinzip an sich bekannt, aber es funktioniert in der Praxis leider nicht so ohne Weiteres, die Betriebs-Gase einfach mit dem Ziel einer höheren Schallgeschwindigkeit auszutauschen, denn ohne ein Gas mit hoher Dichte und damit geringerer Schallgeschwindigkeit, wie etwa Stickstoff, erhält man keine gute Gas-Lagerung des MAS-Rotors.

### Aufgabe der Erfindung

Der vorliegenden Erfindung liegt demgegenüber die Aufgabe zugrunde, unter Verwendung der konventionellen MAS-Statoren, wie sie für eine NMR-Apparatur mit den eingangs definierten Merkmalen üblich sind, die Rotationsgeschwindigkeit der MAS-Rotoren zu maximieren.

Die Notwendigkeit einer speziellen Auslegung der MAS-Statoren auf leichte Gase soll dabei erfindungsgemäß vermieden werden.

Bei diesen bekannten MAS-Statoren sind die körperlichen Gaszuführungen für die Antriebs- und Lagergasströme bereits räumlich getrennt. Die bisher üblichen Ausström-Düsen sollen aber aufgrund der vorliegenden Erfindung nicht notwendigerweise angepasst werden müssen.

Wichtig ist auch die Möglichkeit zu einer Effizienzsteigerung derart, dass der MAS-Rotor bereits bei möglichst geringen angelegten Drücken mit einer hohen Rotationsfrequenz betrieben werden kann. Die Drücke sollen dabei stabil sein, sodass bei der NMR-Messung möglichst geringe Rotationsschwankungen auftreten.

### Kurze Beschreibung der Erfindung

Diese komplexe Aufgabe wird mit der vorliegenden Erfindung auf ebenso überraschend einfache wie wirkungsvolle Weise durch ein Verfahren zum Betrieb einer NMR-Apparatur der eingangs definierten Art dadurch gelöst, dass dem MAS-Stator mindestens zwei unterschiedliche Gase oder Gasgemische durch die getrennten Gaszuführungen zugeführt werden, wobei eines der mindestens zwei verschiedenen Gase oder Gasgemische dem MAS-Stator für den Antrieb des MAS-Rotors durch eine erste Gaszuführung, ein anderes, davon unterschiedliches Gas oder Gasgemisch für die Lagerung des MAS-Rotors durch eine zweite Gaszuführung zugeführt wird, dass eine Druckbeaufschlagung der mindestens zwei unterschiedlichen Gase oder Gasgemische vor ihrer Zufuhr in den MAS-Stator jeweils separat geregelt wird, und dass die unterschiedlichen Gase oder Gasgemische X; Y an einer Vermischung im MAS-Stator mittels einer im MAS-Stator angeordneten Spüldichtung gehindert werden, durch welche die unterschiedlichen Gase oder Gasgemische X; Y für den Antrieb des MAS-Rotors und für die Lagerung des MAS-Rotors aus dem MAS-Stator ausströmen.

Die Grund-Idee der vorliegenden Erfindung ist es, für jede Funktion im MAS-System ein besonderes geeignetes Gas oder Gasgemisch zu benutzen. Die vorliegende Erfindung schlägt also vor, eine konsequente Trennung der Gasführung und Gasaufbereitung zu implementieren.

Gerade aufgrund der Erfindung eröffnen sich jetzt bisher ungeahnte Möglichkeiten einer Funktions-spezifischen Optimierung der für die Lagerung des MAS-Rotors und dessen Antrieb eingesetzten Gase in einer MAS-Mikrogasturbine für die Festkörper NMR.

Die in der Regel in einem klassischen MAS-System bereits vorhandenen räumlich getrennten Gaszuführungen für die Beschickung des MAS-Rotors mit Lager- und Antriebsgas können nun durch die Erfindung auch ohne körperlichen Umbau unmittelbar mit einer unterschiedlichen Gaszusammensetzung für Lagerung und Antrieb genutzt werden.

Die zu verwendenden Gase oder Gasgemische können ohne Weiteres so gewählt werden, dass auch weiterhin elektrische Überschläge an der HF-Spule der NMR-Apparatur ausgeschlossen werden können.

Weiterhin soll eine Regeleinheit bereitgestellt werden, die die unterschiedlichen Gasströme insbesondere hinsichtlich des beaufschlagten Druckes regelt und die Zusammensetzung derselben einstellbar macht.

Helium darf nicht in die Lagerung gelangen, um die Lagersteifigkeit nicht zu vermindern. Umgekehrt wird die Schallgeschwindigkeit durch N₂ herabgesetzt. Daher darf das Lagergas nicht in den Antriebsbereich gelangen. Eine effiziente Trennung mittels der Spüldichtung ist also erforderlich, denn Lager und Antrieb sollen ja erfindungsgemäß entkoppelt sein.

Optional ist auch (weiterhin) ein Temperiergasstrom (VT) zur Temperierung des MAS-Rotors und somit der NMR-Probe möglich. Dessen Beschickung kann wiederum mit einem eigens dafür optimierten Gas oder Gasgemisch, insbesondere freilich auch mit dem verwendeten Lagergas oder dem Antriebsgas, erfolgen.

Das VT-Gas wird im Stator direkt an den Rotor abgegeben bzw. ist auf den Rotor gerichtet, wo auch die Spule sitzt. Durch die entsprechende Wahl eines separaten Temperiergases kann somit auch die Spannungsfestigkeit erhöht werden. Durch sinnvolle Auswahl der VT-Gase können die Gaseigenschaften optimiert werden, insbesondere wenn man in die Extrembereiche geht, also sehr hohe oder sehr niedrige Temperaturen. In dem Fall dient das Lagergas auch als Hitzeschild vor zu hohen/niedrigen Temperaturen. Das Temperiergas kann ggf. abgestellt werden, z.B. bei Raumtemperaturmessungen um den Gesamtfluss in der MAS-Turbine zu vermindern.

### Bevorzugte Ausführungsformen der Erfindung

Bei einer ganz besonders bevorzugten Ausführungsform des erfindungsgemäßen Verfahrens werden die über die getrennten Gaszuführungen in den MAS-Stator und den MAS-Rotor zugeführten unterschiedlichen Gase oder Gasgemische aus in eine separate Gasregeleinheit eingeleiteten Roh-Gasen oder Rohgas-Gemischen aufbereitet, bevor sie über die getrennten Gaszuführungen in den MAS-Stator und den MAS-Rotor geleitet werden. Wichtig bei der Gasregeleinheit ist die optimale Steuerung der Gasparameter. Die Druck-, Temperatur und Drehfrequenzsensoren am Stator geben die Informationen an die Regeleinheit ab, die dazu dient, dass die Gasgemische entsprechend ihrer optimalen Zusammensetzung und Druck bzw. Temperatur aufbereitet werden und über separate Gaszuführungen in den MAS-Stator und an den MAS-Rotor geleitet werden.

Das dient auch der Automatisierung mit Hilfe einer Bedieneinheit (Software), in welche der User vorgegebene Parameter eingibt, wie z.B. Frequenz, Temperatur etc. Durch sinnvolle Gemisch-Aufbereitung können auch Kosten eingespart werden, wenn z.B. bei niedrigen Drehfrequenzen teures Helium reduziert wird.

In der Praxis bewähren sich Varianten des erfindungsgemäßen Verfahrens, die sich dadurch auszeichnen, dass der Druck des Gases oder Gasgemisches Y für die Lagerung des MAS-Rotors auf einen Wert zwischen 0,5 und 5 bar und der Druck des Gases oder Gasgemisches X für den Antrieb des MAS-Rotors auf einen Wert zwischen 0 und 10 bar geregelt wird.

Eine genaue Regelung des Drucks und des Flusses ist erforderlich, um stabile Drehzahlen zu erhalten. Eine Abweichung von lediglich 1 mbar führt bereits zu einer Drehzahländerung von 50 Hz. Für präzise stabile Messungen sollte die Abweichung jedoch höchstens 10 Hz betragen. Der Antrieb wird auf den sub-Millibar-Bereich geregelt, was durch händische Regelung nur schwierig möglich wäre. Da man über größere Bereiche messen will, ist auch die Druckregelung über einen großen Bereich notwendig.

Bei weiteren bevorzugten Varianten ist im Gasgemisch Y für die Lagerung des MAS-Rotors N₂ und im Gasgemisch X für den Antrieb des MAS-Rotors Helium vorhanden, und insbesondere wird als Gas Y für die Lagerung des MAS-Rotors trockener Stickstoff verwendet.

N₂ ist inert, hat eine hohe Dichte und ist gut und preisgünstig verfügbar. Somit ist es gut angepasst zur Verwendung als Lagergas. Helium hat eine hohe Schallgeschwindigkeit, somit kann dieses Gas schneller strömen und den MAS-Rotor schneller rotieren.

Vorteilhaft sind auch Verfahrensvarianten, bei welchen als Gasgemisch Y für die Lagerung des MAS-Rotors ein N₂-He-Gemisch mit einem He-Anteil zwischen 0 und 50%, insbesondere zwischen 0 und 30%, verwendet wird. Durch das Gemisch im Lagergas kann die Schallgeschwindigkeit angepasst/erhöht werden. Bei hohen Rotationsgeschwindigkeiten gibt es nämlich die Problematik von Stoßwellen und Turbulenzen bei Erreichen der Überschallgeschwindigkeit, die somit vermieden werden.

Weitere bevorzugte Varianten des erfindungsgemäßen Verfahrens sind dadurch gekennzeichnet, dass als Gas oder Gasgemisch X für den Antrieb des MAS-Rotors zwischen 10% und 100%, insbesondere zwischen 25% und 100%, vorzugsweise zwischen 50% und 100% Helium verwendet wird.

Helium hat eine höhere Schallgeschwindigkeit. Bei niedrigeren Antriebsgeschwindigkeiten kann auch N₂ mit zugeführt werden, denn es hat eine bessere Antriebseffizienz und Verfügbarkeit.

Diese Verfahrensvarianten können noch dadurch verbessert werden, dass das verwendete Helium einen Reinheitsgrad von mindestens 95% (= «Ballongas») aufweist.

5% Verunreinigung hat wenig Einfluss auf die Schallgeschwindigkeit. Daher kann auch technisches, also ganz leicht verunreinigtes und somit preislich günstigeres Helium eingesetzt werden.

Besonders bevorzugt wird bei Varianten des erfindungsgemäßen Verfahrens als Temperiergas für eine Temperierung des MAS-Rotors ein weiteres Gas oder Gasgemisch Z durch eine von der Gaszuführung für die Lagerung des MAS-Rotors sowie von der Gaszuführung für den Antrieb des MAS-Rotors räumlich getrennte zusätzliche Gaszuführung in den MAS-Stator geleitet und ebenfalls separat geregelt.

Die Probe soll gezielt temperiert werden, nicht das gesamte MAS-System. Die Durchschlagsfestigkeit beim HF-Puls kann durch die gezielte Auswahl eines entsprechenden Gases erhöht werden.

Um die Betriebskosten niedrig zu halten, kann bei Weiterbildungen dieser Verfahrensvarianten als Gas oder Gasgemisch Z für die Temperierung des MAS-Rotors trockener Stickstoff, C5-Perfluoriertes Keton (C5-PFK) oder getrocknete und gereinigte Luft verwendet werden.

Das VT-Gas darf sich in dem Temperaturbereich nicht verflüssigen oder gefrieren. Der Taupunkt des VT-Gases soll unter der Zieltemperatur liegen, um die erforderliche Durchschlagsfestigkeit sicherzustellen.

In den Rahmen der vorliegenden Erfindung fällt auch eine NMR-Apparatur die zur Durchführung des Verfahrens nach einem der oben beschriebenen Varianten ausgestaltet ist, und die ein MAS-System aufweist mit einer MAS-Turbine umfassend einen MAS-Stator zur Aufnahme eines länglichen MAS-Rotors, wobei im MAS-Stator getrennte Gaszuführungen für die Lagerung und für den Antrieb des MAS-Rotors angeordnet sind, wobei eine Gasregeleinheit vorhanden ist, welche mit zugeführtem Roh-Gas oder Rohgas-Gemisch über getrennte Gaszuleitungen versorgt werden kann, und wobei die Gasregeleinheit dazu ausgelegt ist, das Roh-Gase oder Rohgas-Gemisch für den Gas-Antrieb des MAS-Rotors sowie für die Gas-Lagerung des MAS-Rotors aufzubereiten und mit dem entsprechenden jeweils angepassten Druck zu beaufschlagen sowie über getrennte Gaszuführungen in den MAS-Stator zu leiten, um den Antrieb und die Lagerung des MAS-Rotors in der MAS-Turbine voneinander getrennt zu bewirken. Eine solche NMR-Apparatur zeichnet sich erfindungsgemäß dadurch aus, dass eine Gasregeleinheit vorhanden ist, welche mit mindestens zwei unterschiedlichen zugeführten Roh-Gasen oder Rohgas-Gemischen X'; Y' über getrennte Gaszuleitungen versorgt werden kann, und dass die Gasregeleinheit dazu ausgelegt ist, die Roh-Gase oder Rohgas-Gemische X'; Y' als unterschiedlich zusammengesetzte gasförmige Medien X; Y für den Gas-Antrieb des MAS-Rotors sowie für die Gas-Lagerung des MAS-Rotors aufzubereiten und mit dem entsprechenden jeweils angepasstem Druck zu beaufschlagen sowie über getrennte Gaszuführungen in den MAS-Stator zu leiten, um den Antrieb und die Lagerung des MAS-Rotors in der MAS-Turbine voneinander getrennt zu bewirken, und dass die MAS-Turbine eine Spüldichtung umfasst, die zwischen Antriebsdüsen und Lagerdüsen als Ausströmeinrichtung für die Antriebs- und Lagergase X; Y angeordnet und so ausgelegt ist, dass mindestens ein Teil des Lagergases Y durchgeleitet wird, um zu verhindern, dass das Antriebsgas X in den Bereich einer NMR-Spule gelangt.

Die Gasregeleinheit dient der optimierten und automatisierten Regelung der Gasströme, wie oben bereits beschrieben. Der Benutzer muss lediglich die Zieldaten in eine Software eingeben und die Regeleinheit regelt dann die Zusammensetzung der Gase und die jeweilige Druckeinstellung, die erforderlich ist, um die Ziele zu erreichen. Die Regeleinheit verarbeitet die entsprechenden Sensorinformationen aus dem MAS-Stator und passt die Ströme an.

Des Weiteren kann man Sicherheitsaspekte integrieren, sowohl für die Messung, um Rotorbruch zu vermeiden, als auch für den Nutzer selbst bei Sauerstoffknappheit am Arbeitsplatz, wenn eine Notabschaltung vorhanden ist.

Bei vorteilhaften Ausführungsformen der erfindungsgemäßen NMR-Apparatur ist die Gasregeleinheit mit einem Frequenzsensor an der MAS-Turbine zur Einstellung des Drucks und/oder der Zusammensetzung der Antriebs- und Lagergase X; Y verbunden.

Bevorzugt ist auch eine Klasse von Ausführungsformen der erfindungsgemäßen NMR-Apparatur, welche sich dadurch auszeichnen, dass der MAS-Stator eine räumlich getrennte zusätzliche Gaszuführung für die Zufuhr eines weiteren Gases oder Gasgemisches Z als Temperiergas für eine Temperierung des MAS-Rotors aufweist.

Bei vorteilhaften Weiterbildungen dieser Klasse von Ausführungsformen enthält die Gasregeleinheit jeweils eine getrennte Unter-Regeleinheit zur separaten Regelung der Antriebs-, Lager- und Temperier-Gase X; Y; Z.

Die Gase müssen einzeln regelbar sein, aus den Gründen
- der Antriebseffizienz und hohen Schallgeschwindigkeit (Antriebsgas X),
- der Lagertragfähigkeit/Lagersteifigkeit (Lagergas Y)
- der Temperierung (Temperiergas Z), denn für die Temperierung sind der Fluss des VT-Gases und die thermische Masse entscheidend.

Die Druckregelung dient insbesondere einer konstanten Geschwindigkeit.

Bevorzugt sind auch Ausführungsformen der Erfindung, bei denen die Gasregeleinheit mit einem Temperatursensor an der MAS-Turbine zur Einstellung der Temperatur des Temperiergases verbunden ist.

Ein Temperaturfühler ist erforderlich, um die Probentemperatur konstant zu halten. Die Daten vom Temperatursensor erlauben einen Rückschluss auf die Temperatureinstellung des VT-Gases.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine grob-schematische Darstellung einer Ausführungsform der erfindungsgemäßen MAS-Turbine im Vertikalschnitt;
- Fig. 2: Graphiken der Rotationsfrequenz f_{ROT} (kHz) jeweils als Funktion des Antriebsdrucks p_{DRIVE} (bar) mit drei unterschiedlichen Lager- und Antriebsgasen bzw. Gasgemischen;
- Fig. 3a: ein schematisches Funktions-Schema für das erfindungsgemäße Gasmanagement eines MAS-Systems mit Gaszufuhr- und Regelsystem für eine MAS-Turbine in einer Ausführungsform zur Aufbereitung zweier Gase; und
- Fig. 3b: wie Fig. 3a, jedoch in einer Ausführungsform zur Aufbereitung von drei Gasen.

Die vorliegende Erfindung befasst sich mit einem Verfahren zum Betrieb einer NMR-Apparatur, die ein MAS-System aufweist mit einer MAS-Turbine 10 umfassend einen **MAS-Stator 11** zur Aufnahme eines länglichen **MAS-Rotors 12,** wobei im MAS-Stator 11 **getrennte Gaszuführungen 13'; 13" für die Lagerung und für den Antrieb** des MAS-Rotors 12 angeordnet sind.

Gegenstand der Erfindung ist auch eine entsprechend modifizierte NMR-Apparatur.

Die vorliegende Erfindung zeichnet sich gegenüber herkömmlichen Betriebsverfahren nach dem Stand der Technik dadurch aus, dass dem MAS-Stator 11 mindestens zwei **unterschiedliche Gase oder Gasgemische X; Y** durch die getrennten Gaszuführungen 13'; 13" zugeführt werden, wobei eines der mindestens zwei verschiedenen Gase oder Gasgemische X dem MAS-Stator 11 für den Antrieb des MAS-Rotors 12 durch eine erste Gaszuführung 13', ein anderes, davon unterschiedliches Gas oder Gasgemisch Y für die Lagerung des MAS-Rotors 12 durch eine zweite Gaszuführung 13" zugeführt wird, und dass eine Druckbeaufschlagung der mindestens zwei unterschiedlichen Gase oder Gasgemische X; Y vor ihrer Zufuhr in den MAS-Stator 11 jeweils separat geregelt wird.

Die körperlichen Zuführungen für Lagergas und Antriebsgas sind in den meisten der bisher bekannten MAS-Systemen zwar räumlich getrennt angeordnet, jedoch wird durch diese getrennten Gaszuführungen bisher dem MAS-System immer nur ein und dasselbe Gas bzw. Gasgemisch für Lagerung und Antrieb zugeführt.

Reines Helium ist allerdings in N₂-optimierten Lagern als Lagergas ungeeignet. Es stellt sich wegen der geringeren Viskosität kein funktionierendes Gaskissen zwischen dem MAS-Rotor 12 und dem MAS-Stator 11 ein.

Durch den Austausch des Antriebsgases, das bei schnellen Systemen 20% des zum Betrieb benötigten Gases ausmacht, wird die Kostensteigerung für den Anwender begrenzt. Erfindungsgemäß wird vorgeschlagen, als Antriebsgas Helium zu verwenden, um somit höhere Drehzahlen zu ermöglichen. Neben Helium können auch andere Inertgase in geringen Mengen zugemischt werden. Typischerweise wird in MAS-Turbinen N₂ als Antriebsgas verwendet. Die Effizienz bei der Verwendung von Stickstoff ist freilich gering, weil die resultierende Rotationsfrequenz bei gegebenem Druck geringer ist als beispielsweise bei Helium. Auch die resultierende maximal erreichbare Frequenz ist wegen der niedrigeren Schallgeschwindigkeit geringer.

Ein vorteilhafter Effekt stellt sich bereits bei 10% Helium ein. Vorzugsweise ist der Anteil von Helium im Antriebsgas größer 25%, um die Effizienz signifikant zu steigern. Besonders bevorzugt ist ein Anteil im Bereich 50%-100%.

Die NMR-Spule befindet sich weiterhin in einer Stickstoff-basierten Atmosphäre durch die Lagergaszufuhr, wodurch elektrische Überschläge vermieden werden können. Das Lagergas kann aber auch neben Stickstoff bis zu 33% Helium enthalten, ohne dass elektrische Überschläge stattfinden. Die SpannungsFestigkeit ist insbesondere abhängig von der Feldstärke des eingestrahlten HF-Feldes. Bei der NMR-Spektroskopie gilt, dass eine möglichst große Leistung in die Probe eingestrahlt wird, um das magnetische B1-Feld zu maximieren. Daher ist es wichtig die Zusammensetzung des Lagergases derart anzupassen, dass die Spannungsfestigkeit bei der hohen Feldstärke gegeben ist.

Die körperlichen Teile der Lagerung müssen bei Anwendung der Erfindung *nicht* an die neue Gasdynamik angepasst werden, wodurch viele Aufwände in der Entwicklung entfallen, d.h. Düsenöffnungen und Lagerspaltbreiten zwischen MAS-Rotor und MAS-Stator werden nicht angepasst.

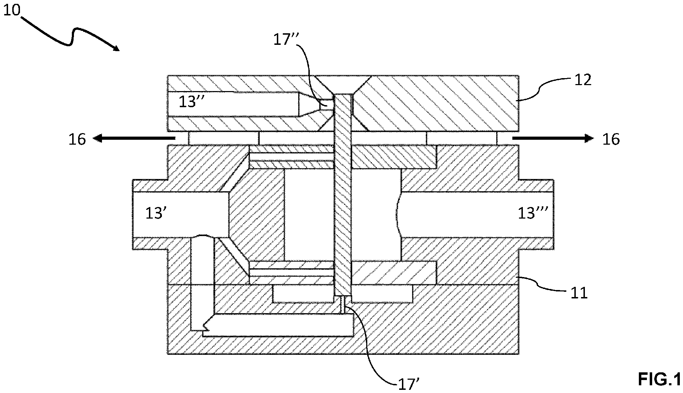

Um zu vermeiden, dass das Antriebgas in den Bereich der das HF-Feld erzeugenden NMR-Spule gelangt, die im Wesentlichen in der Mitte des MAS-Rotors 12 angeordnet ist, wird eine **Spüldichtung 16** zwischen oberem Lager und dem Antrieb eingesetzt. **Fig. 1** zeigt eine derartige erfindungsgemäß modifizierte MAS-Turbine 10 mit Spüldichtung 16, angedeutet durch zwei gegenläufige Pfeile.

Die Spüldichtung 16 ist ausgebildet als Gasauslass, der vorzugsweise ringförmig zwischen den **Lagerdüsen 17'** und den **Antriebsgasdüsen 17"** angeordnet ist, wie in Fig. 1 zu erkennen ist. Durch die Verwendung dieser Spüldichtung 16 ist es möglich, dass zwei unterschiedliche Gase oder Gasgemische für den Antrieb und die Lagerung verwendet werden, ohne dass diese sich im Messbereich vermischen. Insbesondere die Verwendung von Helium als Antriebsgas würde die Spannungsfestigkeit der Spule im Messbereich herabsetzen, was durch die Spüldichtung 16 vermieden wird. Somit kann das MAS-System mit hohen Feldstärken bei gleichzeitig hohen Rotationsfrequenzen betrieben werden.

Idealerweise ist die Spüldichtung 16 so ausgelegt, dass mindestens ein Teil des Lagergases durchgeleitet wird, um zu verhindern, dass das He-basierte Antriebsgas in den Bereich der NMR-Spule gelangt. Üblicherweise genügt der höhere Druck des Lagergases gegenüber dem Antriebsgas. Des Weiteren sorgt eine Konus-förmige Öffnung unterhalb des Antriebs, also dort wo die Rotorkappe sitzt, dafür, dass der Druck des ausströmenden Antriebsgases vermindert wird. Diese konische Aufweitung ist ebenfalls in Fig. 1 zu erkennen.

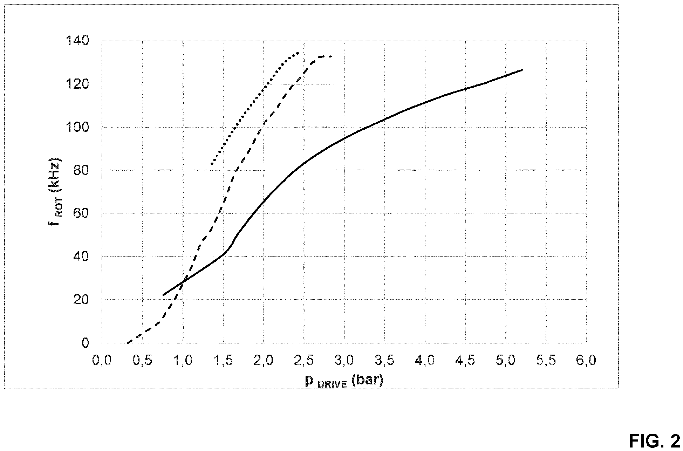

**Fig. 2** zeigt drei Graphiken der Rotationsfrequenz f_{ROT} (kHz) jeweils als Funktion des Antriebsdrucks p_{DRIVE} (bar) mit unterschiedlichen Lager- und Antriebsgasen bzw. Gasgemischen, nämlich
durchgezogene Kurve: N₂-Betrieb, Stand der Technik
gestrichelte Kurve: Antrieb mit Helium, Lagerung mit N₂
gepunktete Kurve: Antrieb mit Helium, Lagerung mit 33% Helium und 67% N₂.

Hier wurde ein herkömmlicher MAS-Stator verwendet für einen zylindrischen MAS-Rotor mit 0,7mm Durchmesser. Es fällt auf, dass die gemessene Rotationfrequenz f_{ROT} beim Antrieb mit Helium höhere Werte erreicht. Überraschenderweise werden die höheren Frequenzen bei deutlich niedrigerem Antriebsdrucks p_{DRIVE} des Antriebsgases erreicht. Diese Effizienzsteigerung wird zusätzlich verbessert, wenn ein Teil des N₂ Lagergases durch 1/3 Helium ersetzt wird (gepunktete oberste Kurve).

Der Betrieb des Systems bei niedrigeren Drücken hat den Vorteil, dass die mechanische Belastung geringer ist; hohe Drücke bedeuten, dass höhere Energie im pneumatischen System vorhanden ist, was zu Zerstörung führen kann. Ein Abbruch der Kurven bei hohen Drücken erfolgt, weil sich die Kappe verformt und schleift.

Die unterschiedlichen Funktionen (Antrieb, Lagerung; Temperierung) der MAS-Turbine 10 werden erfindungsgemäß mit unterschiedlichen Gasen realisiert. Dadurch lassen sich für jede Funktion (Antrieb, Lagerung; Temperierung) jeweils optimale Gase einsetzen. Denkbar sind neben den erwähnten Gasen N₂ und Helium auch CO₂ und SF₆. Letztere zeichnen sich durch eine hohe Spannungsfestigkeit und hohe Dichte aus, weshalb sie gut als Lagergas aber auch gut als VT-Gase für die Temperierung eingesetzt werde können. H₂ hat ähnlich vorteilhafte Eigenschaften wie He und könnte theoretisch als Antriebsgas Verwendung finden. Jedoch ist aufgrund der Brennbarkeit von H₂ eine Abtrennung erforderlich.

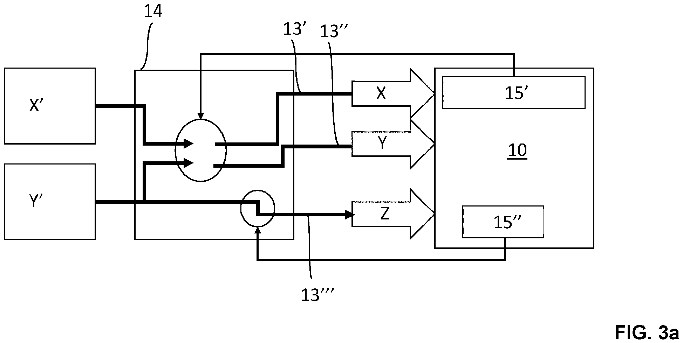

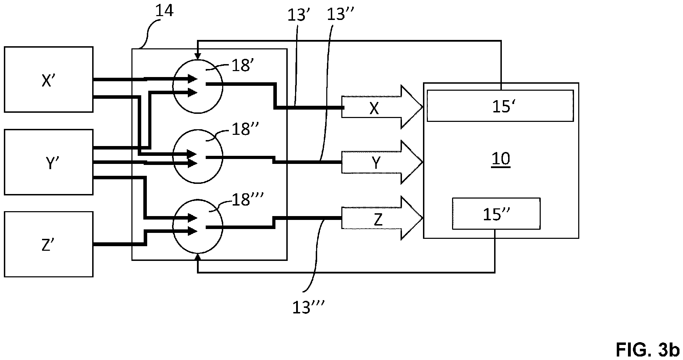

In den **Figuren 3a** **und** **3b** ist schematisch dargestellt, wie ein erfindungsgemäßes Gasmanagement aussehen kann:
Die über die getrennten Gaszuführungen 13'; 13" in den MAS-Stator 11 und den MAS-Rotor 12 zugeführten unterschiedlichen Gase oder Gasgemische X; Y aus in eine separate **Gasregeleinheit 14** eingeleiteten **Roh-Gasen oder Rohgas-Gemischen X'; Y'; Z'** werden aufbereitet, bevor sie über die getrennten Gaszuführungen 13'; 13" in den MAS-Stator 11 und den MAS-Rotor 12 geleitet werden. Die Gasregeleinheit 14 ist dazu ausgelegt, die Roh-Gase oder Rohgas-Gemische X'; Y' als unterschiedlich zusammengesetzte gasförmige Medien X; Y für den Gas-Antrieb des MAS-Rotors 12 sowie für die Gas-Lagerung des MAS-Rotors 12 aufzubereiten und mit dem entsprechenden jeweils angepasstem Druck zu beaufschlagen sowie über die getrennten Gaszuführungen 13'; 13" in den MAS-Stator 11 zu leiten, um den Antrieb und die Lagerung des MAS-Rotors 12 in der MAS-Turbine 10 voneinander getrennt zu bewirken.

Die Verwendung einer derartigen Gasregeleinheit 14 ist insbesondere vorteilhaft in Laboren, in welchen die Druckgasversorgung variabel ist, denn die Gasregeleinheit 14 ist dazu ausgelegt, die Gasströme mit optimierten Drücken in das MAS-System einzuspeisen.

Als Temperiergas für eine Temperierung des MAS-Rotors 12 kann ein **weiteres Gas oder Gasgemisch Z** durch eine von der Gaszuführung 13' für die Lagerung des MAS-Rotors 12 sowie von der Gaszuführung 13" für den Antrieb des MAS-Rotors 12 räumlich getrennte **zusätzliche Gaszuführung 13‴** in den MAS-Stator 11 geleitet und ebenfalls separat geregelt werden. Typischerweise ist das VT-Gas ein kostengünstiges Inertgas wie z.B. N₂, welches elektrische Überschläge verhindert.

Die Gasregeleinheit 14 ist mit einem **Frequenzsensor 15'** an der MAS-Turbine 10 zur Einstellung des Drucks und/oder der Zusammensetzung der Antriebs- und Lagergase X; Y sowie mit einem **Temperatursensor 15"** zur Messung der Temperatur des Temperiergases verbunden.

In **Fig. 3a** werden zwei unterschiedliche Gase, die mit Druck beaufschlagt sind, in eine P/T Regeleinheit 14 eingespeist. Entsprechend den Anforderungen des MAS-Systems wird der Druck ggf. heruntergeregelt und in die MAS-Turbine 10 abgegeben. Die Aufbereitung der Gase in der Regeleinheit 14 ist insbesondere hinsichtlich der Rotationsgeschwindigkeit des MAS-Rotors 12 erforderlich. Lagergas und Antriebsgas können mit unterschiedlichem Druck geregelt werden. Insbesondere ist es möglich, über die Regeleinheit 14 Gasgemische enthaltend die Gase X und Y in ihrer Zusammensetzung für die Lagerung und den Antrieb aufzubereiten. Vorzugsweise kann mittels eines Frequenzsensors 15' in der MAS-Turbine 10 die Rotationsgeschwindigkeit des MAS-Rotors 12 gemessen und als in-line Kontrolle an die Regeleinheit 14 weitergegeben werden, um den jeweiligen Druck anzupassen, bzw. das jeweilige Gasgemisch in der Zusammensetzung zu optimieren.

**Fig. 3b** schließlich zeigt eine Ausführungsform, in der bis zu drei Gase kombiniert werden können und auch das Temperiergas Z zum Gemisch aufbereitet werden kann. Das dritte Gas Z kann sinnvoll sein, wenn eine hohe Spannungsfestigkeit erforderlich ist. Dann kann beispielsweise SF₆ als Gas Z hinzugefügt werden, welches elektrisch gut isolierend ist. Die Gasregeleinheit 14 enthält jeweils eine getrennte **Unter-Regeleinheit 18'; 18"; 18‴** zur separaten Regelung der Antriebs-, Lager- und Temperier-Gase X; Y; Z.

### Bezugszeichenliste:

- 10: MAS-Turbine
- 11: MAS-Stator
- 12: MAS-Rotor
- 13'; 13": räumlich getrennte körperliche Gaszuführungen für die Lagerung und für den Antrieb des MAS-Rotors
- 13‴: zusätzliche Gaszuführung für die Zufuhr eines Temperiergases
- 14: Gasregeleinheit
- 15': Frequenzsensor
- 15": Temperatursensor
- 16: Spüldichtung
- 17': Lagerdüsen
- 17": Antriebsdüsen
- 18'; 18"; 18‴: Unter-Regeleinheiten
- X: Gas oder Gasgemisch für den Antrieb des MAS-Rotors
- Y: Gas oder Gasgemisch für die Lagerung des MAS-Rotors
- Z: Gas oder Gasgemisch für die Temperierung des MAS-Rotors
- X'; Y'; Z': zugeführte Rohgas-Gemische

### Referenzliste:

Für die Beurteilung der Patentfähigkeit in Betracht gezogene Publikationen:
[0] JIANG, Y. J., et al. Efficient stator/rotor assembly for magic-angle spinning NMR. Review of scientific instruments, 1987, 58. Jg., Nr. 5, S. 755-758. DOI: https://doi.org/10.1063/1.1139626 [recherchiert und aufgerufen am 01.12.2023]
[1] US 5 508 615 A
[2] Journal of Magnetic Resonance 195 (2008) 179-186
[3] EP 3 301 467 B1 ≈ US 10 459 044 B2 ≈ JP 6517896 B2 ≈ CN 107870309 B
[4] US 2010/0026302 A1
[5] Chem. Sci. (2015) 6, 6806
[6] US 9 995 802 B2
[7] WO 2021/097382 A1
[8] Review of Scientific Instruments 42, 618 (1971)

## Patentansprüche

1. Verfahren zum Betrieb einer NMR-Apparatur, die ein MAS-System aufweist mit einer MAS-Turbine (10) umfassend einen MAS-Stator (11) zur Aufnahme eines länglichen MAS-Rotors (12), wobei im MAS-Stator (11) getrennte Gaszuführungen (13'; 13") für die Lagerung und für den Antrieb des MAS-Rotors (12) angeordnet sind, wobei dem MAS-Stator (11) ein Gas oder Gasgemisch (X; Y) durch die getrennten Gaszuführungen (13'; 13") zugeführt wird, wobei ein Gas oder Gasgemisch (X) dem MAS-Stator (11) für den Antrieb des MAS-Rotors (12) durch eine erste Gaszuführung (13') und für die Lagerung des MAS-Rotors (12) durch eine zweite Gaszuführung (13") zugeführt wird, und wobei eine Druckbeaufschlagung des Gases oder Gasgemisches (X; Y) vor der Zufuhr in den MAS-Stator (11) jeweils separat geregelt wird,
**dadurch gekennzeichnet,**
**dass** dem MAS-Stator (11) mindestens zwei unterschiedliche Gase oder Gasgemische (X; Y) durch die getrennten Gaszuführungen (13'; 13") zugeführt werden, wobei eines der mindestens zwei verschiedenen Gase oder Gasgemische (X) dem MAS-Stator (11) für den Antrieb des MAS-Rotors (12) durch eine erste Gaszuführung (13'), ein anderes, davon unterschiedliches Gas oder Gasgemisch (Y) für die Lagerung des MAS-Rotors (12) durch eine zweite Gaszuführung (13") zugeführt wird,
**dass** eine Druckbeaufschlagung der mindestens zwei unterschiedlichen Gase oder Gasgemische (X; Y) vor ihrer Zufuhr in den MAS-Stator (11) jeweils separat geregelt wird, und
**dass** die unterschiedlichen Gase oder Gasgemische (X; Y) an einer Vermischung im MAS-Stator (11) mittels einer im MAS-Stator (11) angeordneten Spüldichtung (16) gehindert werden, durch welche die unterschiedlichen Gase oder Gasgemische (X; Y) für den Antrieb des MAS-Rotors (12) und für die Lagerung des MAS-Rotors (12) aus dem MAS-Stator (11) zumindest anteilig ausströmen.

2. Verfahren nach Anspruch 1, **dadurch gekennzeichnet, dass** die über die getrennten Gaszuführungen (13'; 13") in den MAS-Stator (11) und den MAS-Rotor (12) zugeführten unterschiedlichen Gase oder Gasgemische (X; Y) aus in eine separate Gasregeleinheit (14) eingeleiteten Roh-Gasen oder Rohgas-Gemischen (X'; Y') aufbereitet werden, bevor sie über die getrennten Gaszuführungen (13'; 13") in den MAS-Stator (11) und den MAS-Rotor (12) geleitet werden.

3. Verfahren nach einem der vorhergehenden Ansprüche, **dadurch gekennzeichnet, dass** der Druck des Gases oder Gasgemisches (Y) für die Lagerung des MAS-Rotors (12) auf einen Wert zwischen 0,5 und 5 bar und der Druck des Gases oder Gasgemisches (X) für den Antrieb des MAS-Rotors (12) auf einen Wert zwischen 0 und 10 bar geregelt wird.

4. Verfahren nach einem der vorhergehenden Ansprüche, **dadurch gekennzeichnet, dass** im Gasgemisch (Y) für die Lagerung des MAS-Rotors (12) N₂ und im Gasgemisch (X) für den Antrieb des MAS-Rotors (12) Helium vorhanden ist, und insbesondere, dass als Gas (Y) für die Lagerung des MAS-Rotors (12) trockener Stickstoff verwendet wird.

5. Verfahren nach einem der vorhergehenden Ansprüche, **dadurch gekennzeichnet, dass** als Gasgemisch (Y) für die Lagerung des MAS-Rotors (12) ein N₂-He-Gemisch mit einem He-Anteil zwischen 0 und 50%, insbesondere zwischen 0 und 30%, verwendet wird.

6. Verfahren nach einem der vorhergehenden Ansprüche, **dadurch gekennzeichnet, dass** als Gas oder Gasgemisch (X) für den Antrieb des MAS-Rotors (12) zwischen 10% und 100%, insbesondere zwischen 25% und 100%, vorzugsweise zwischen 50% und 100% Helium verwendet wird.

7. Verfahren nach Anspruch 6, **dadurch gekennzeichnet, dass** das verwendete Helium einen Reinheitsgrad von mindestens 95% (= «Ballongas») aufweist.

8. Verfahren nach einem der vorhergehenden Ansprüche, **dadurch gekennzeichnet, dass** als Temperiergas für eine Temperierung des MAS-Rotors (12) ein weiteres Gas oder Gasgemisch (Z) durch eine von der Gaszuführung (13') für die Lagerung des MAS-Rotors (12) sowie von der Gaszuführung (13") für den Antrieb des MAS-Rotors (12) räumlich getrennte zusätzliche Gaszuführung (13‴) in den MAS-Stator (11) geleitet und ebenfalls separat geregelt wird.

9. Verfahren nach Anspruch 8, **dadurch gekennzeichnet, dass** als Gas oder Gasgemisch (Z) für die Temperierung des MAS-Rotors (12) trockener Stickstoff, C5-Perfluoriertes Keton (C5-PFK) oder getrocknete und gereinigte, Luft verwendet wird.

10. NMR-Apparatur, die zur Durchführung des Verfahrens nach einem der vorhergehenden Ansprüche ausgestaltet ist, und die ein MAS-System aufweist mit einer MAS-Turbine (10) umfassend einen MAS-Stator (11) zur Aufnahme eines länglichen MAS-Rotors (12), wobei im MAS-Stator (11) getrennte Gaszuführungen (13'; 13") für die Lagerung und für den Antrieb des MAS-Rotors (12) angeordnet sind, wobei eine Gasregeleinheit (14) vorhanden ist, welche mit zugeführtem Roh-Gas oder Rohgas-Gemisch (X'; Y') über getrennte Gaszuleitungen versorgt werden kann, und wobei die Gasregeleinheit (14) dazu ausgelegt ist, das Roh-Gas oder Rohgas-Gemisch (X'; Y') für den Gas-Antrieb des MAS-Rotors (12) sowie für die Gas-Lagerung des MAS-Rotors (12) aufzubereiten und mit dem entsprechenden jeweils angepassten Druck zu beaufschlagen sowie über getrennte Gaszuführungen (13'; 13") in den MAS-Stator (11) zu leiten, um den Antrieb und die Lagerung des MAS-Rotors (12) in der MAS-Turbine (10) voneinander getrennt zu bewirken,
**dadurch gekennzeichnet,**
**dass** eine Gasregeleinheit (14) vorhanden ist, welche mit mindestens zwei unterschiedlichen zugeführten Roh-Gasen oder Rohgas-Gemischen (X'; Y') über getrennte Gaszuleitungen versorgt werden kann,
**dass** die Gasregeleinheit (14) dazu ausgelegt ist, die Roh-Gase oder Rohgas-Gemische (X'; Y') als unterschiedlich zusammengesetzte gasförmige Medien (X; Y) für den Gas-Antrieb des MAS-Rotors (12) sowie für die Gas-Lagerung des MAS-Rotors (12) aufzubereiten und mit dem entsprechenden jeweils angepassten Druck zu beaufschlagen sowie über getrennte Gaszuführungen (13'; 13") in den MAS-Stator (11) zu leiten, um den Antrieb und die Lagerung des MAS-Rotors (12) in der MAS-Turbine (10) voneinander getrennt zu bewirken, und
**dass** die MAS-Turbine (10) eine Spüldichtung (16) umfasst, die zwischen Antriebsdüsen (17") und Lagerdüsen (17') als Ausströmeinrichtung für die Antriebs- und Lagergase (X; Y) angeordnet und so ausgelegt ist, dass mindestens ein Teil des Lagergases (Y) durchgeleitet wird, um zu verhindern, dass das Antriebsgas (X) in den Bereich einer NMR-Spule gelangt.

11. NMR-Apparatur nach Anspruch 10, **dadurch gekennzeichnet, dass** die Gasregeleinheit (14) mit einem Frequenzsensor (15') an der MAS-Turbine (10) zur Einstellung des Drucks und/oder der Zusammensetzung der Antriebs- und Lagergase (X; Y) verbunden ist.

12. NMR-Apparatur nach einem der Ansprüche 10 oder 11, **dadurch gekennzeichnet, dass** der MAS-Stator (11) eine räumlich getrennte zusätzliche Gaszuführung (13‴) für die Zufuhr eines weiteren Gases oder Gasgemisches (Z) als Temperiergas für eine Temperierung des MAS-Rotors (12) aufweist.

13. NMR-Apparatur nach Anspruch 12, **dadurch gekennzeichnet, dass** die Gasregeleinheit (14) jeweils eine getrennte Unter-Regeleinheit (18'; 18"; 18‴) zur separaten Regelung der Antriebs-, Lager- und Temperier-Gase (X; Y; Z) enthält.

## Claims

1. A method for operating a nuclear magnetic resonance (NMR) apparatus having a magic angle spinning (MAS) system with an MAS turbine (10) comprising an MAS stator (11) for receiving an oblong MAS rotor (12), wherein separate gas feeds (13'; 13") for bearing and for driving of the MAS rotor (12) are arranged in the MAS stator (11), wherein a gas or gas mixture (X; Y) is fed to the MAS stator (11) through the separate gas feeds (13'; 13"), wherein a gas or gas mixture (X) is fed to the MAS stator (11) for the drive of the MAS rotor (12) through a first gas feed (13') and is fed through a second gas feed (13") for the bearing of the MAS rotor (12), and wherein a pressurization of the gas or gas mixture (X; Y) is regulated separately in each case before being fed into the MAS stator (11),
**characterized in**
**that** at least two different gases or gas mixtures (X; Y) are fed to the MAS stator (11) through the separate gas feeds (13'; 13"), wherein one of the at least two different gases or gas mixtures (X) is fed to the MAS stator (11) for the drive of the MAS rotor (12) through a first gas feed (13'), another gas or gas mixture (Y), which is different therefrom, for the bearing of the MAS rotor (12) is fed through a second gas feed (13"),
**that** a pressurization of the at least two different gases or gas mixtures (X; Y) is regulated separately in each case before they are fed into the MAS stator (11), and
**that** the different gases or gas mixtures (X; Y) are prevented from mixing in the MAS stator (11) by means of a flushing seal (16) arranged in the MAS stator (11), through which the different gases or gas mixtures (X; Y) for the drive of the MAS rotor (12) and for the bearing of the MAS rotor (12) at least partially flow out of the MAS stator (11).

2. The method according to Claim 1, **characterized in that** the different gases or gas mixtures (X; Y) fed via the separate gas feeds (13'; 13") into the MAS stator (11) and the MAS rotor (12) are prepared from raw gases or raw gas mixtures (X'; Y') introduced into a separate gas regulating unit (14), before they are conducted via the separate gas feeds (13'; 13") into the MAS stator (11) and the MAS rotor (12).

3. The method according to any one of the preceding claims, **characterized in that** the pressure of the gas or gas mixture (Y) for the bearing of the MAS rotor (12) is regulated to a value between 0.5 and 5 bar and the pressure of the gas or gas mixture (X) for the drive of the MAS rotor (12) is regulated to a value between 0 and 10 bar.

4. The method according to any one of the preceding claims, **characterized in that** N₂ is present in the gas mixture (Y) for the bearing of the MAS rotor (12) and helium is present in the gas mixture (X) for the drive of the MAS rotor (12), and in particular that dry nitrogen is used as the gas (Y) for the bearing of the MAS rotor (12).

5. The method according to any one of the preceding claims, **characterized in that** an N₂-He mixture having a He proportion between 0 and 50%, in particular between 0 and 30%, is used as the gas mixture (Y) for the bearing of the MAS rotor (12).

6. The method according to any one of the preceding claims, **characterized in that** between 10% and 100%, in particular between 25% and 100%, preferably between 50% and 100% helium is used as the gas or gas mixture (X) for the drive of the MAS rotor (12).

7. The method according to Claim 6, **characterized in that** the helium used has a degree of purity of at least 95% (= "balloon gas").

8. The method according to any one of the preceding claims, **characterized in that**, as the temperature control gas for a temperature control of the MAS rotor (12), a further gas or gas mixture (Z) is conducted through an additional gas feed (13‴), which is spatially separate from the gas feed (13') for the bearing of the MAS rotor (12) and from the gas feed (13") for the drive of the MAS rotor (12), into the MAS stator (11) and is also separately regulated.

9. The method according to Claim 8, **characterized in that** dry nitrogen, C5-perfluorinated ketone (C5-PFK), or dried and purified air is used as the gas or gas mixture (Z) for the temperature control of the MAS rotor (12).

10. A nuclear magnetic resonance (NMR) apparatus which is designed to perform the method according to any one of the preceding claims and has a magic angle spinning (MAS) system with an MAS turbine (10) comprising:
an MAS stator (11) for receiving an oblong MAS rotor (12), wherein separate gas feeds (13'; 13") for bearing and for driving of the MAS rotor (12) are arranged in the MAS stator (11), wherein
a gas regulating unit (14) is provided that can be supplied with fed raw gas or raw gas mixture (X'; Y') via separate gas feed lines, and wherein the gas regulating unit (14) is designed to prepare the raw gas or raw gas mixture (X'; Y') for the gas drive of the MAS rotor (12) and for the gas bearing of the MAS rotor (12) and to apply the corresponding respective adapted pressure thereto and to conduct it via separate gas feeds (13'; 13") into the MAS stator (11) in order to effectuate the drive and the bearing of the MAS rotor (12) in the MAS turbine (10) separately from one another,
**characterized in**
**that** a gas regulating unit (14) is provided which can be supplied with at least two different fed raw gases or raw gas mixtures (X'; Y') via separate gas feed lines;
**that** the gas regulating unit (14) is designed to prepare the raw gases or raw gas mixtures (X'; Y') as gaseous media (X; Y), which have different compositions, for the gas drive of the MAS rotor (12) and for the gas bearing of the MAS rotor (12) and to apply the corresponding respective adapted pressure thereto and to conduct them via separate gas feeds (13'; 13") into the MAS stator (11) in order to effectuate the drive and the bearing of the MAS rotor (12) in the MAS turbine (10) separately from one another; and
**that** the MAS turbine (10) comprises a flushing seal (16), which is arranged between drive nozzles (17") and bearing nozzles (17') as an outflow device for the drive and bearing gases (X; Y) and is designed so that at least a part of the bearing gas (Y) is conducted through to prevent the drive gas (X) from reaching the region of an NMR coil.

11. The NMR apparatus according to Claim 10, **characterized in that** the gas regulating unit (14) is connected to a frequency sensor (15') on the MAS turbine (10) for setting the pressure and/or the composition of the drive and bearing gases (X; Y).

12. The NMR apparatus according to Claim 10 or 11, **characterized in that** the MAS stator (11) has a spatially separate additional gas feed (13‴) for the feed of a further gas or gas mixture (Z) as a temperature control gas for a temperature control of the MAS rotor (12).

13. The NMR apparatus according to Claim 12, **characterized in that** the gas regulating unit (14) contains a separate sub-regulating unit (18'; 18"; 18"') in each case for the separate regulation of the drive, bearing and temperature control gases (X; Y; Z).

## Revendications

1. Procédé de fonctionnement d'un appareil RMN comprenant un système MAS avec une turbine MAS (10) comprenant un stator MAS (11) permettant d'accueillir un rotor MAS (12) allongé, des alimentations en gaz (13'; 13") séparées destinées à la mise sur palier et à l'entraînement du rotor MAS (12) étant agencées dans le stator MAS (11), un gaz ou un mélange gazeux (X ; Y) étant alimenté vers le stator MAS (11) grâce aux alimentations en gaz (13' ; 13") séparées, un gaz ou un mélange gazeux (X) étant alimenté vers le stator MAS (11) grâce à une première alimentation en gaz (13') en vue de l'entraînement du rotor MAS (12) et grâce à une deuxième alimentation en gaz (13") en vue de la mise sur palier du rotor MAS (12), et une mise sous pression du gaz ou du mélange gazeux (X ; Y) étant régulée de manière respectivement séparée avant l'alimentation dans le stator MAS (11),
**caractérisé en ce que**
au moins deux gaz ou mélanges de gaz (X ; Y) différents sont alimentés vers le stator MAS (11) grâce aux alimentations en gaz (13'; 13") séparées, un parmi les au moins deux gaz ou mélanges de gaz (X) différents étant alimenté vers le stator MAS (11) grâce à une première alimentation en gaz (13') en vue de l'entraînement du rotor MAS (12) et un autre gaz ou mélange de gaz (Y) différent étant alimenté grâce à une deuxième alimentation en gaz (13") en vue de la mise sur palier du rotor MAS (12), une mise sous pression des au moins deux gaz ou mélanges gazeux (X ; Y) différents est régulée de manière respectivement séparée avant leur alimentation dans le stator MAS (11), et
les gaz ou mélanges de gaz (X ; Y) différents sont empêchés de se mélanger dans le stator MAS (11) au moyen d'un joint de rinçage (16) qui est agencé dans le stator MAS (11) et grâce auquel les gaz ou mélanges de gaz (X ; Y) différents sortent au moins en partie du stator MAS (11) en vue de l'entraînement du rotor MAS (12) et de la mise sur palier du rotor MAS (12).

2. Procédé selon la revendication 1, **caractérisé en ce que** les gaz ou mélanges de gaz (X ; Y) différents alimentés dans le stator MAS (11) et le rotor MAS (12) par l'intermédiaire des alimentations en gaz (13'; 13") séparées sont préparés à partir de gaz bruts ou de mélanges de gaz bruts (X' ; Y') acheminés dans une unité de régulation de gaz (14) séparée avant d'être acheminés dans le stator MAS (11) et le rotor MAS (12) par l'intermédiaire des alimentations en gaz (13' ; 13") séparées.

3. Procédé selon l'une quelconque des revendications précédentes, **caractérisé en ce que** la pression du gaz ou du mélange gazeux (Y) pour la mise sur palier du rotor MAS (12) est régulée à une valeur comprise entre 0,5 et 5 bars et la pression du gaz ou du mélange gazeux (X) pour l'entraînement du rotor MAS (12) est régulée à une valeur comprise entre 0 et 10 bars.

4. Procédé selon l'une quelconque des revendications précédentes, **caractérisé en ce que** du N₂ est présent dans le mélange gazeux (Y) en vue de la mise sur palier du rotor MAS (12) et de l'hélium est présent dans le mélange gazeux (X) en vue de l'entraînement du rotor MAS (12), et en particulier **en ce que** de l'azote sec est utilisé comme gaz (Y) en vue de la mise sur palier du rotor MAS (12).

5. Procédé selon l'une quelconque des revendications précédentes, **caractérisé en ce qu'**un mélange N₂-He avec une proportion de He comprise entre 0 et 50 %, en particulier comprise entre 0 et 30 %, est utilisé comme mélange gazeux (Y) en vue de la mise sur palier du rotor MAS (12).

6. Procédé selon l'une quelconque des revendications précédentes, **caractérisé en ce qu'**une proportion comprise entre 10 % et 100 %, en particulier comprise entre 25 % et 100 %, de manière préférée comprise entre 50 % et 100 % d'hélium est utilisée pour le gaz ou mélange gazeux (X) destiné à l'entraînement du rotor MAS (12).

7. Procédé selon la revendication 6, **caractérisé en ce que** l'hélium utilisé présente un degré de pureté d'au moins 95 % (= « gaz pour ballon »).

8. Procédé selon l'une quelconque des revendications précédentes, **caractérisé en ce qu'**un autre gaz ou mélange gazeux (Z) est acheminé, en tant que gaz de régulation de température pour une régulation de température du rotor MAS (12), dans le stator MAS (11), et est également régulé séparément, grâce à une alimentation en gaz (131) supplémentaire spatialement séparée de l'alimentation en gaz (13') pour la mise sur palier du rotor MAS (12) et spatialement séparée de l'alimentation en gaz (13") pour l'entraînement du rotor MAS (12).

9. Procédé selon la revendication 8, **caractérisé en ce que** de l'azote sec, de la cétone perfluorée en C5 (C5-PFK) ou de l'air séché et purifié est utilisé€ comme gaz ou mélange gazeux (Z) en vue de la régulation de température du rotor MAS (12).

10. Appareil RMN conçu pour la mise en œuvre du procédé selon l'une quelconque des revendications précédentes et présentant un système MAS avec une turbine MAS (10) comprenant un stator MAS (11) permettant d'accueillir un rotor MAS (12) allongé, des alimentations en gaz (13'; 13") séparées étant agencées dans le stator MAS (11) en vue de la mise sur palier et de l'entraînement du rotor MAS (12), une unité de régulation de gaz (14) étant présente, laquelle peut être alimentée en gaz brut ou en mélange de gaz brut (X' ; Y') par l'intermédiaire de conduites d'alimentation en gaz séparées, et l'unité de régulation de gaz (14) étant conçue pour préparer le gaz brut ou le mélange de gaz brut (X' ; Y') destiné à l'entraînement par gaz du rotor MAS (12) et à la mise sur palier par gaz du rotor MAS (12) et le mettre à la pression respectivement adaptée correspondante et l'acheminer dans le stator MAS (11) par l'intermédiaire d'alimentations en gaz (13' ; 13") séparées, afin de provoquer l'entraînement et la mise sur palier, séparément l'un de l'autre, du rotor MAS (12) au sein de la turbine MAS (10),
**caractérisé en ce que**
une unité de régulation de gaz (14) est présente, laquelle peut être alimentée par au moins deux gaz bruts ou mélanges de gaz bruts (X' ; Y') différents par l'intermédiaire de conduites d'alimentation en gaz séparées,
l'unité de régulation de gaz (14) est conçue pour préparer les gaz bruts ou les mélanges de gaz bruts (X' ; Y') sous forme de milieux gazeux (X ; Y) de différentes compositions en vue de l'entraînement par gaz du rotor MAS (12) et de la mise sur palier par gaz du rotor MAS (12) et pour les mettre à la pression respectivement adaptée correspondante, et pour les acheminer dans le stator MAS (11) par l'intermédiaire des alimentations en gaz (13'; 13") séparées, afin de provoquer l'entraînement et la mise sur palier, séparément l'un de l'autre, du rotor MAS (12) au sein de la turbine MAS (10), et
la turbine MAS (10) comprend un joint de rinçage (16) qui est agencé entre des buses d'entraînement (17") et des buses de palier (1T) en tant que dispositif d'échappement pour les gaz d'entraînement et de palier (X ; Y) et qui est conçu de sorte qu'au moins une partie du gaz de palier (Y) est guidé afin d'empêcher le gaz d'entraînement (X) de pénétrer dans la région d'une bobine RMN.

11. Appareil de RMN selon la revendication 10, **caractérisé en ce que** l'unité de régulation de gaz (14) est reliée à un capteur de fréquence (15') au niveau de la turbine MAS (10) en vue de l'ajustement de la pression et/ou de la composition des gaz d'entraînement et de mise sur palier (X ; Y).

12. Appareil de RMN selon l'une quelconque des revendications 10 ou 11, **caractérisé en ce que** le stator MAS (11) présente une alimentation en gaz (131) supplémentaire spatialement séparée et destinée à l'alimentation d'un autre gaz ou mélange de gaz (Z) en tant que gaz de régulation de température pour une régulation de température du rotor MAS (12).

13. Appareil RMN selon la revendication 12, **caractérisé en ce que** l'unité de régulation de gaz (14) contient respectivement une sous-unité de régulation (18'; 18"; 18"') séparée permettant une régulation séparée des gaz d'entraînement, de mise sur palier et de régulation de température (X ; Y ; Z).
